# EUROPEAN PATENT APPLICATION

(11) **EP 4 772 071 A1**
(43) Date of publication of application: **08.07.2026**
(21) Application number: 25190163.3
(22) Date of filing: 17.07.2025
(51) Int. Cl.: A47B 88/50, A47B 88/493, H05K 7/14

(54) **SLIDE RAIL ASSEMBLY**

(30) Priority: 07.01.2025 TW 114100783
(71) Applicant: King Slide Works Co., Ltd., Kaohsiung City 821 (TW); King Slide Technology Co., Ltd., 82151 Kaohsiung City (TW)
(72) Inventor: Chen, Ken-Ching, 821 Kaohsiung City (TW); Yang, Shun-Ho, 821 Kaohsiung City (TW); Ho, Chun-Yi, 821 Kaohsiung City (TW); Wang, Chun-Chiang, 821 Kaohsiung City (TW)
(74) Representative: Straus, Alexander

(57) **Abstract**

A slide rail assembly (20) adapted for a rack is provided and includes a first rail (22), a second rail (24) and a mounting fitting (26). A first bracket (30) is arranged on the first rail (22). The first rail (22) is mounted on the rack by the first bracket (30). The second rail (24) is displaceable relative to the first rail (22) longitudinally. The mounting fitting (26) includes a connecting portion (48). One of the first rail (22) and the first bracket (30) includes a predetermined feature (46). When the second rail (24) is located at a retracted position (R) relative to the first rail (22) and the connecting portion (48) of the mounting fitting (26) is detachably connected to the predetermined feature (46), the mounting fitting (26) prevents the second rail (24) from displacing away from the retracted position (R) in an opening direction (D1).

## Description

### Field of the Invention

The present invention relates to a slide rail assembly according to the pre-characterizing clause of claim 1.

### Background of the Invention

Generally, a slide rail assembly is a device configured to be mounted on a cabinet body and used to support a carried object, such as an electronic apparatus or a drawer, which allows the carried object to move relative to the cabinet body, e.g., by means of a movable rail of the slide rail assembly. However, during transportation of the cabinet body, if the slide rail assembly is mounted on the cabinet body with no carried object, the movable rail may unintentionally displace to an extended position due to unexpected external forces caused by vibration or shaking, thereby increasing a risk of damage to the slide rail assembly.

Currently, it is common to use a cable tie to secure the slide rail assembly for preventing the slide rail assembly from being opened. However, a tool, such as scissors, is required to cut the cable tie, which is inconvenient in use. In addition, the looseness or tightness of the cable tie is manually controlled by the user, which may affect the stability and reliability of the security of the slide rail assembly.

Accordingly, it has become an important issue to provide a product capable of preventing a slide rail assembly from being unintentionally opened.

### Summary of the Invention

This is mind, the present invention aims at providing a slide rail assembly having a first rail, a second rail, and a tool-free detachable mounting fitting configured to prevent the second rail from displacing relative to the first rail in an opening direction.

This is achieved by a slide rail assembly according to claim 1. The dependent claims pertain to corresponding further developments and improvements.

As will be seen more clearly from the detail description following below, the claimed slide rail assembly is adapted for a rack. The slide rail assembly includes a first rail, a second rail and a mounting fitting. A first bracket is arranged on the first rail. The first rail is mounted on the rack by the first bracket. The second rail is displaceable relative to the first rail longitudinally. The mounting fitting includes a connecting portion. One of the first rail and the first bracket includes a predetermined feature. When the second rail is located at a retracted position relative to the first rail and the connecting portion of the mounting fitting is detachably connected to the predetermined feature, the mounting fitting prevents the second rail from displacing away from the retracted position in an opening direction.

In summary, by the mounting fitting detachably mounted on the slide rail assembly, the present invention can prevent the second rail from displacing relative to the first rail in an opening direction. Therefore, the present invention offers enhanced operational convenience.

These and other objectives of the present invention will no doubt become obvious to those of ordinary skill in the art after reading the following detailed description of the preferred embodiment that is illustrated in the various figures and drawings.

### Brief Description of the Drawings

In the following, the invention is further illustrated by way of example, taking reference to the accompanying drawings. Thereof:
FIG. 1 is a schematic diagram of a slide rail assembly with a mounting fitting according to an embodiment of the present invention,
FIG. 2 is an exploded diagram of the slide rail assembly according to the embodiment of the present invention,
FIG. 3 is a diagram of the mounting fitting according to the embodiment of the present invention,
FIG. 4 is a diagram illustrating that the slide rail assembly is mounted on a rack without the mounting fitting according to the embodiment of the present invention,
FIG. 5 is a diagram illustrating that the slide rail assembly is mounted on the rack without the mounting fitting and a second rail displaces relative to a first rail to an extended position unintentionally according to the embodiment of the present invention,
FIG. 6 is a diagram of the slide rail assembly mounted on the rack and the mounting fitting not mounted on the first bracket according to the embodiment of the present invention,
FIG. 7 is an enlarged diagram of an A portion as shown in FIG. 6,
FIG. 8 is a diagram of the slide rail assembly mounted on the rack and the mounting fitting mounted on the first bracket according to the embodiment of the present invention,
FIG. 9 is an enlarged diagram of a B portion as shown in FIG. 8,
FIG. 10 is an enlarged diagram of a C portion as shown in FIG. 8, and
FIG. 11 is a sectional diagram of the slide rail assembly according to the embodiment of the present invention.

### Detailed Description

In the following detailed description of the preferred embodiments, reference is made to the accompanying drawings which form a part hereof, and in which is shown by way of illustration specific embodiments in which the invention may be practiced. In this regard, directional terminology, such as "top", "bottom", "left", "right", "front", "back", etc., is used with reference to the orientation of the Figure(s) being described. The components of the present invention can be positioned in a number of different orientations. As such, the directional terminology is used for purposes of illustration and is in no way limiting. Accordingly, the drawings and descriptions will be regarded as illustrative in nature and not as restrictive. Also, if not specified, the term "connect" is intended to mean either an indirect or direct mechanical connection. Thus, if a first device is connected to a second device, that connection may be through a direct mechanical connection, or through an indirect mechanical connection via other devices and connections. As used herein, the term "rack" may also refer to a cabinet structure unless otherwise specified.

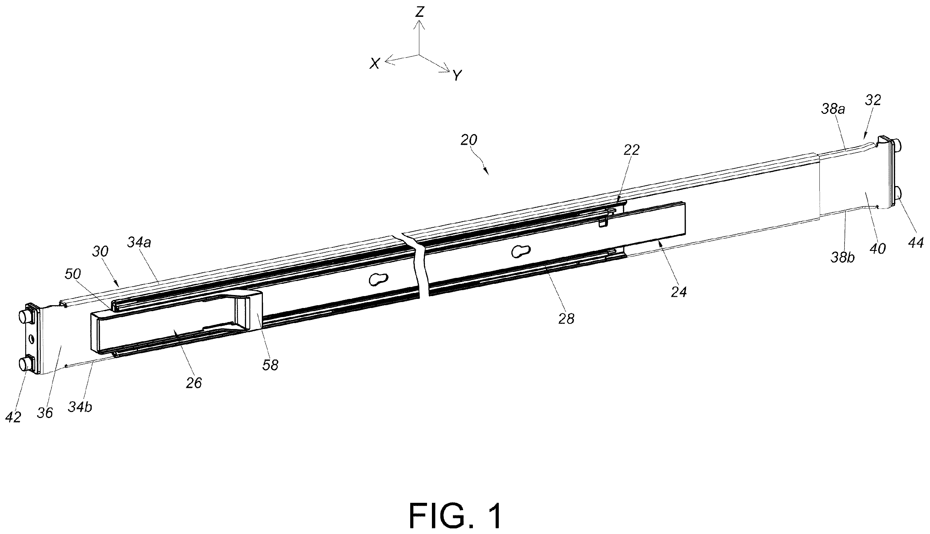

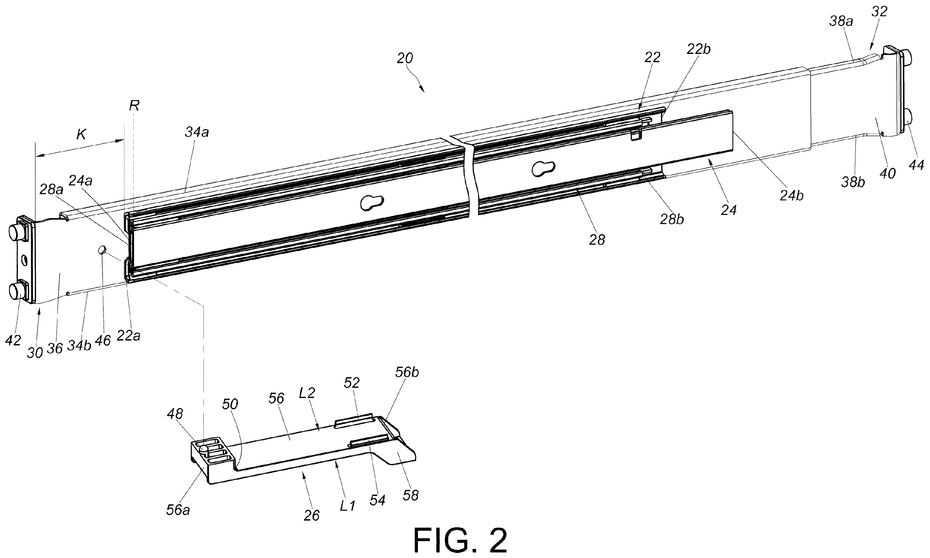

As shown in FIG. 1 and FIG. 2, a slide rail assembly 20 includes a first rail 22, a second rail 24 and a mounting fitting 26. Preferably, the slide rail assembly 20 further includes a third rail 28 movably mounted between the first rail 22 and the second rail 24, and the second rail 24 and the third rail 28 can displace relative to the first rail 22 in a longitudinal direction. For example, the first rail 22, the second rail 24 and the third rail 28 can be an outer rail, an inner rail and a middle rail. In this embodiment, by way of example, the longitudinal direction can be defined by a length direction of a slide rail, e.g., the first rail 22, the second rail 24 or the third rail 28, and parallel to an X axis. A transverse direction can be defined by a lateral direction of the slide rail, e.g., the first rail 22, the second rail 24 or the third rail 28, and parallel to a Y axis. A vertical direction can be defined by a height direction of the slide rail, e.g., the first rail 22, the second rail 24 or the third rail 28. The first rail 22 has a first side and a second side opposite to the first side. For example, the first side and the second side of the first rail 22 can be an outer side and an inner side of the first rail 22, respectively.

Preferably, the slide rail assembly 20 further includes a first bracket 30 and a second bracket 32. For example, the first bracket 30 and the second bracket 32 can be a front bracket and a rear bracket, respectively. The first bracket 30 is arranged on the first rail 22. Furthermore, the first bracket 30 is fixedly connected to the first side of the first rail 22, and therefore the first bracket 30 and the first rail 22 can be considered as an integrated structure. The second bracket 32 and the first bracket 30 are displaceable relative to each other longitudinally. In this embodiment, by way of example, the second bracket 32 and the first bracket 30 are connected to each other in a telescopic manner, such that the second bracket 32 and the first bracket 30 are displaceable relative to each other in the longitudinal direction. Specifically, the first bracket 30 includes a first edge wall 34a, a second edge wall 34b and a lateral wall 36 connected between the first edge wall 34a and the second edge wall 34b of the first bracket 30. Similarly, the second bracket 32 includes a first edge wall 38a, a second edge wall 38b and a lateral wall 40 connected between the first edge wall 38a and the second edge wall 38b of the second bracket 32. Additionally, a first end plate is arranged on an end portion of the lateral wall 36 of the first bracket 30 and provided with at least one first mounting member 42, and a second end plate is arranged on an end portion of the lateral wall 40 of the second bracket 32 and provided with at least one second mounting member 44.

One of the first rail 22 and the first bracket 30 includes a predetermined feature 46. In this embodiment, by way of example, the first bracket 30 includes the predetermined feature 46, and the predetermined feature 46 is a hole defined by a plurality of hole walls. However, the present invention is not limited to this embodiment.

Preferably, the first rail 22 has a first end 22a and a second end 22b opposite to the first end 22a. For example, the first end 22a and the second end 22b of the first rail 22 can be a front end and a rear end of the first rail 22, respectively. Furthermore, the lateral wall 36 of the first bracket 30 exceeds the first end 22a of the first rail 22 by a predetermined longitudinal distance K, and the predetermined feature 46 is arranged on a section of the lateral wall 36 of the first bracket 30 exceeding the first end 22a of the first rail 22.

The second rail 24 and the third rail 28 are located at the second side of the first rail 22. The second rail 24 can be a support rail configured to support a carried object, such as an electronic apparatus or a drawer, which is not shown in the figures. The second rail 24 has a first end 24a and a second end 24b opposite to the first end 24a. For example, the first end 24a and the second end 24b of the second rail 24 can be a front end and a rear end of the second rail 24, respectively. The third rail 28 has a first end 28a and a second end 28b opposite to the first end 28a. For example, the first end 28a and the second end 28b of the third rail 28 can be a front end and a rear end of the third rail 28, respectively. Furthermore, when both the second rail 24 and the third rail 28 are located at a retracted position R relative to the first rail 22, the first end 24a of the second rail 24 and the first end 28a of the third rail 28 are located adjacent to the first end 22a of the first rail 22.

The mounting fitting 26 is configured to be connected to the predetermined feature 46. In this embodiment, by way of example, the mounting fitting 26 is connected to the predetermined feature 46 in a detachable manner, and the mounting fitting 26 can be connected to or detached from the predetermined feature 46 according to practical demands.

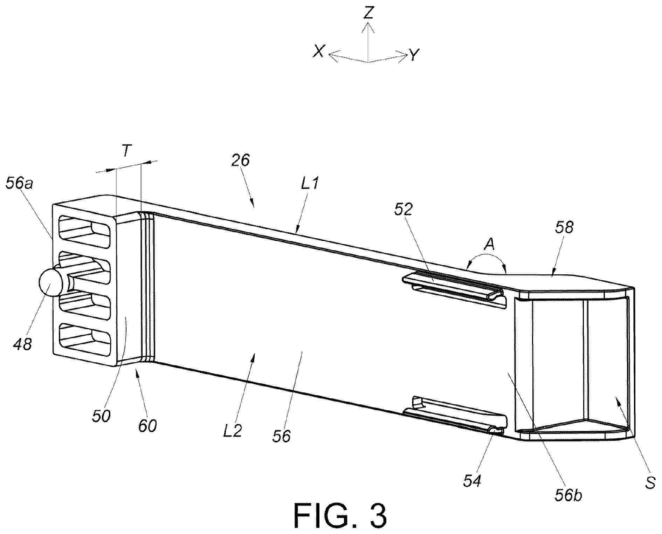

As shown in FIG. 2 and FIG. 3, the mounting fitting 26 includes a connecting portion 48 and a blocking portion 50.

Preferably, the mounting fitting 26 further includes a first engaging portion 52 and a second engaging portion 54. The first engaging portion 52 and the second engaging portion 54 have substantially symmetrical structures. Furthermore, the first engaging portion 52 and the second engaging portion 54 are spaced from each other by a distance in the height direction and located at positions corresponding to each other.

Preferably, the mounting fitting 26 further includes an extending arm 56. The extending arm 56 has a first end 56a and a second end 56b. For example, the first end 56a and the second end 56b of the extending arm 56 can be a front end and a rear end of the extending arm 56, respectively. However, the present invention is not limited thereto. The connecting portion 48 is located adjacent to the first end 56a of the extending arm 56. The first engaging portion 52 and the second engaging portion 54 are located adjacent to the second end 56b of the extending arm 56.

Preferably, the mounting fitting 26 further includes an operating portion 58. Furthermore, the mounting fitting 26 has a first side L1 and a second side L2 opposite to the first side L1. For example, the first side L1 and the second side L2 of the mounting fitting 26 can be an inner side and an outer side of the mounting fitting 26, respectively. The operating portion 58 is located adjacent to the second end 56b of the extending arm 56, and the connecting portion 48, the first engaging portion 52 and the second engaging portion 54 are located at the second side L2 of the mounting fitting 26.

Preferably, the operating portion 58 is connected to the extending arm 56 and located adjacent to the second end 56b of the extending arm 56. The operating portion 58 is tilted at a predetermined angle A relative to the second end 56b of the extending arm 56 and extends from the first side L1 of the mounting fitting 56. Besides, the operating portion 58 exceeds the second end 56b of the extending arm 56, and the operating portion 58 includes an auxiliary space S for insertion of a user's finger(s) from the second side L2 of the mounting fitting 26, so as to facilitate the user to exert an operating force onto the second side L2 of the mounting fitting 26 easily.

Preferably, the connecting portion 48 is a protrusion, and the connecting portion 48 is configured to be connected to the predetermined feature 46, e.g., in an inserting manner.

Preferably, a predetermined structure 60 is arranged on the second side L2 of the mounting fitting 26. The predetermined structure 60 protrudes from the second side L2 of the mounting fitting 26 by a transversal distance T. The blocking portion 50 is formed on the predetermined structure 60. For example, the blocking portion 50 can be an erected wall portion located adjacent to the first end 56a of the extending arm 56. Besides, the connecting portion 48 is formed on the predetermined structure 60. For example, the connecting portion 48 can protrude from the predetermined structure 60.

Preferably, both the first engaging portion 52 and the second engaging portion 54 protrude from the second side L2 of the mounting fitting 26.

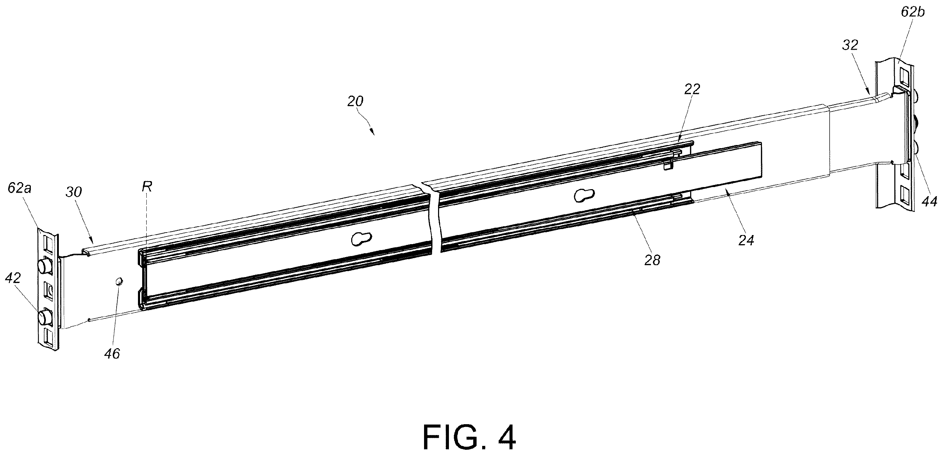

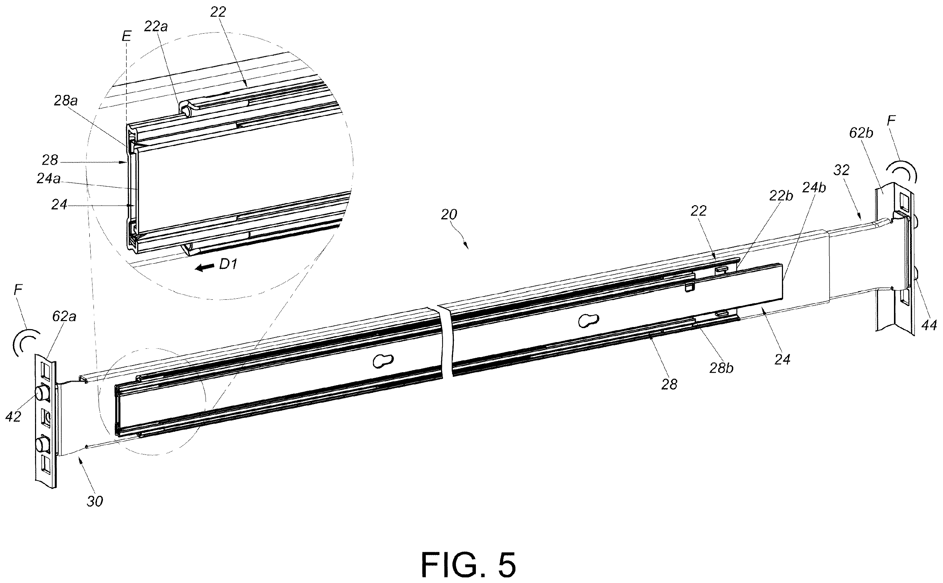

As shown in FIG. 4 and FIG. 5, the slide rail assembly 20 is adapted for a rack. As previously mentioned, the term "rack" as used herein may refer to either a rack-type frame or a cabinet-type enclosure. The rack includes a first post 62a and a second post 62b. For example, the first post 62a and the second post 62b can be a front post and a rear post, respectively. However, the present invention is not limited thereto. The first mounting member 42 of the first bracket 30 and the second mounting member 44 of the second bracket 32 can be mounted on the first post 62a and the second post 62b, respectively, for mounting the first rail 22 or the slide rail assembly 20 on the rack. In this embodiment, by way of example, the first mounting member 42 of the first bracket 30 and the second mounting member 44 of the second bracket 32 can be inserted into an inserting hole on the first post 62a and an inserting hole on the second post 62b, respectively, for mounting the first rail 22 or the slide rail assembly 20 on the rack.

Furthermore, when the mounting fitting 26 is not mounted on the first bracket 30, i.e., when the mounting fitting 26 is not connected to the predetermined feature 46, the second rail 24 and the third rail 28 may displace relative to the first rail 22 from the retracted position (as shown in FIG. 4) to an extended position E (as shown in FIG. 5) or even a position beyond the extended position in an opening direction D1 unintentionally due to unexpected external forces exerting on the first rail 22 and/or the first post 62a and the second post 62b of the rack caused by vibration or shaking. As a result, the second rail 24, the third rail 28 or any other part of the slide rail assembly 20 may collide with another member, such as a door of the rack, thereby resulting in damage to the slide rail assembly 20. As shown in FIG. 5, when the second rail 24 and the third rail 28 are located at the extended position E, the first end 24a of the second rail 24 and the first end 28a of the third rail 28 exceed the first end 22a of the first rail 22 by a distance in the opening direction D1.

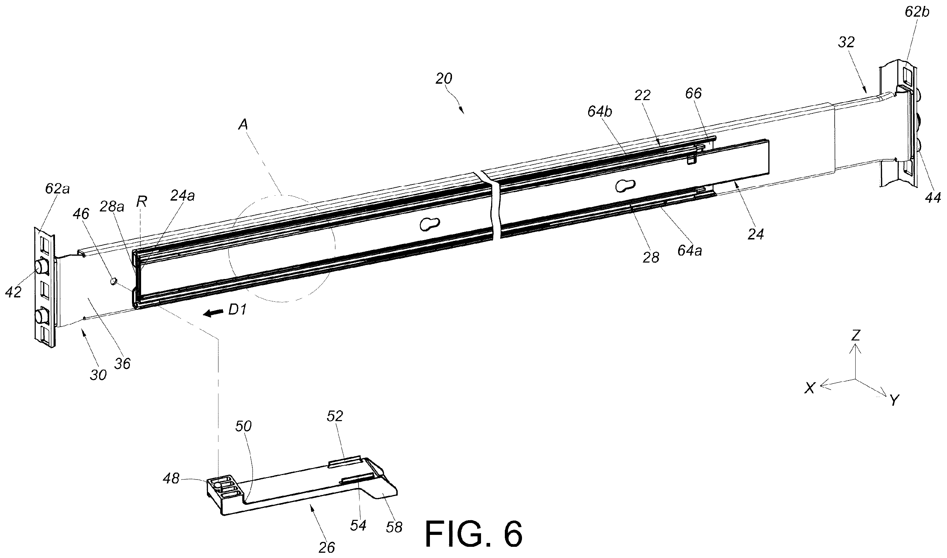

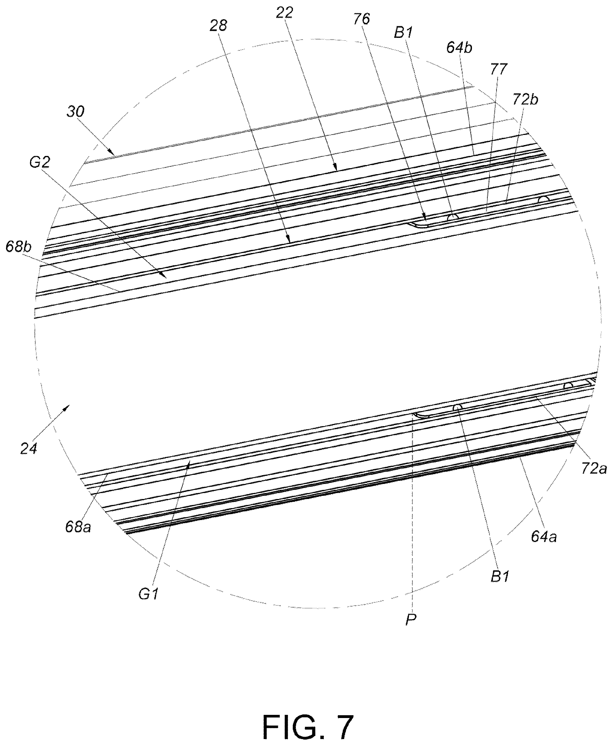

As shown in FIG. 6 and FIG. 7, when both the second rail 24 and the third rail 28 are located at the retracted position R, the mounting fitting 26 can be operated by the user, so as to be detachably connected to the predetermined feature 46, thereby blocking the second rail 24 and the third rail 28 to prevent the second rail 24 and the third rail 28 from displacing away from the retracted position R in the opening direction D1.

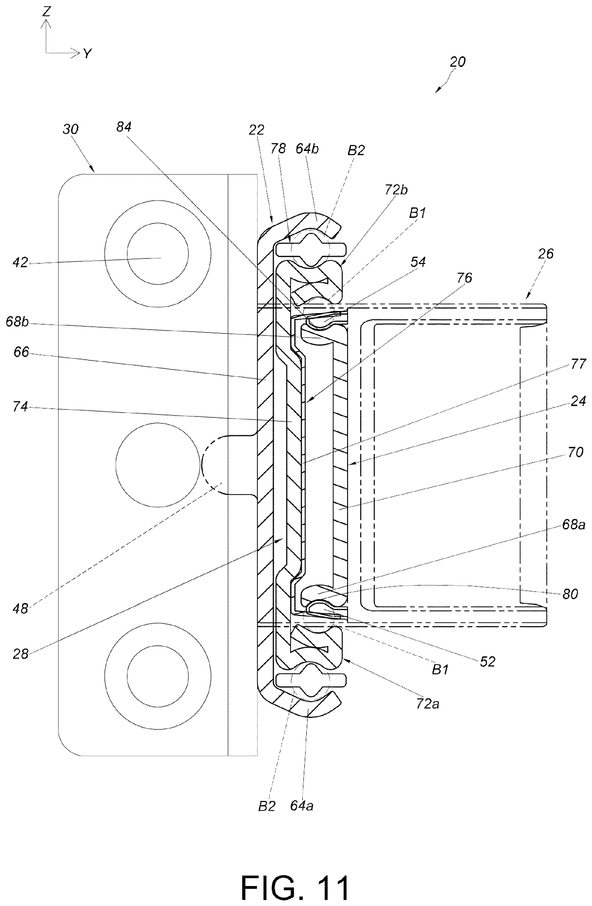

Preferably, as shown in FIG. 11, the first rail 22 includes a first wall 64a, a second wall 64b and a longitudinal wall 66 connected between the first wall 64a and the second wall 64b of the first rail 22. The second rail 24 includes a first wall 68a, a second wall 68b and a longitudinal wall 70 connected between the first wall 68a and the second wall 68b of the second rail 24. The third rail 28 includes a first wall 72a, a second wall 72b and a longitudinal wall 74 connected between the first wall 72a and the second wall 72b of the third rail 28.

Preferably, as shown in FIG. 11, the slide rail assembly 20 further includes an aid-sliding device 76. The aid-sliding device 76 includes a ball retainer 77 and a plurality of first rolling balls B1 rotatably disposed on the ball retainer 77 and configured to be rotatably supported between the first wall 72a of the third rail 28 and the first wall 68a of the second rail 24 and between the second wall 72b of the third rail 28 and the second wall 68b of the second rail 24.

Preferably, as shown in FIG. 11, the slide rail assembly 20 further includes an aid-sliding mechanism 78. The aid-sliding mechanism 78 includes a plurality of second rolling balls B2 configured to be rotatably supported between the first wall 72a of the third rail 28 and the first wall 64a of the first rail 22 and between the second wall 72b of the third rail 28 and the second wall 64b of the first rail 22.

Preferably, when the second rail 24 is located at the retracted position R relative to the first rail 22, the aid-sliding device 76 is located at a predetermined position P. When the aid-sliding device 76 is located at the predetermined position P, the plurality of first rolling balls B1 are neither supported between a non-supporting section of the first wall 72a of the third rail 28 and a non-supporting section of the first wall 68a of the second rail 24 nor between a non-supporting section of the second wall 72b of the third rail 28 and a non-supporting section of the second wall 68b of the second rail 24, such that a first gap G1 is formed between the non-supporting section of the first wall 72a of the third rail 28 and the non-supporting section of the first wall 68a of the second rail 24 and a second gap G2 is formed between the non-supporting section of the second wall 72b of the third rail 28 and the non-supporting section of the second wall 68b of the second rail 24.

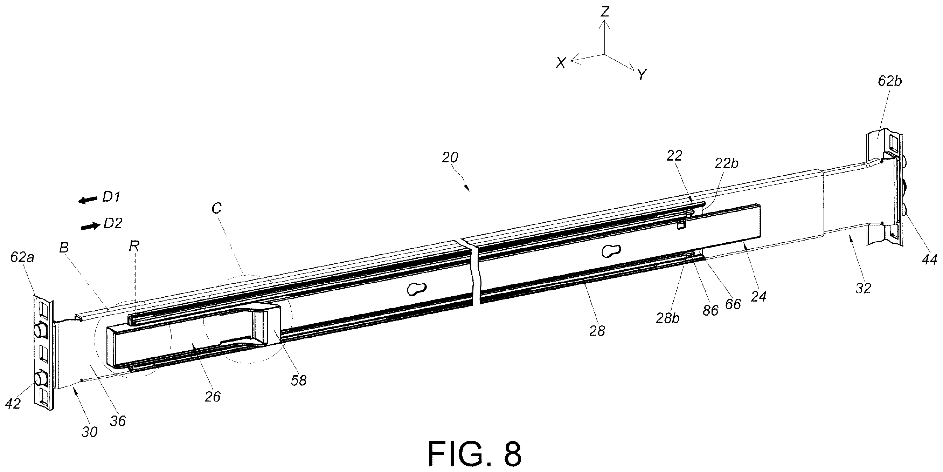

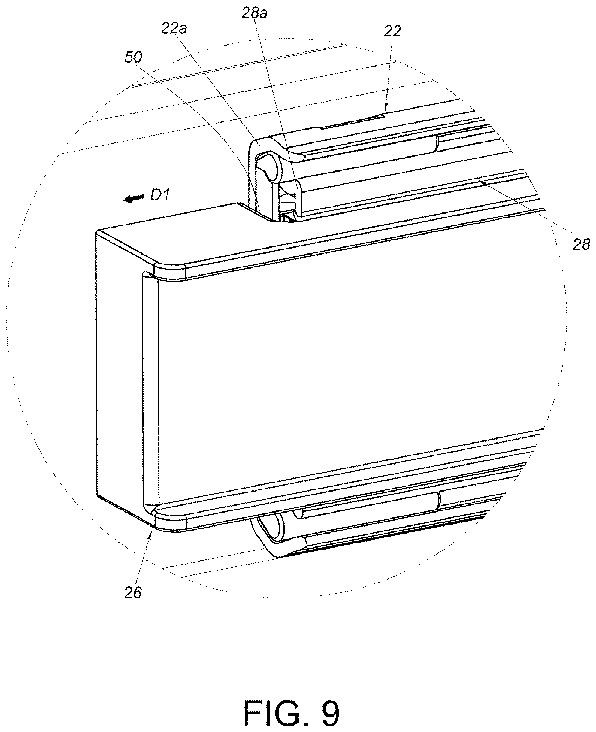

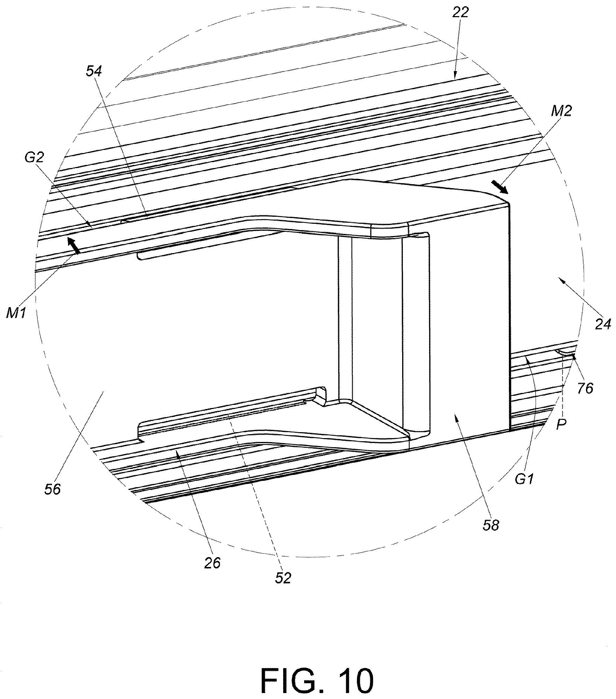

As shown in FIG. 8 to FIG. 11, when both the second rail 24 and the third rail 28 are located at the retracted position R relative to the first rail 22 and the connecting portion 48 of the mounting fitting 26 is connected to the predetermined feature 46, e.g., in the inserting manner, the blocking portion 50 of the mounting fitting 26 is configured to block the second rail 24 and the third rail 28 for preventing the second rail 24 and the third rail 28 from displacing relative to the first rail 22 in the opening direction D1 (as shown in FIG. 9). Preferably, as shown in FIG. 6 and FIG. 9, the blocking portion 50 of the mounting fitting 26 is configured to block the first end 24a of the second rail 24 and the first end 28a of the third rail 28 for preventing the second rail 24 and the third rail 28 from being driven to displace away from the retracted position R in the opening direction D1 by the unexpected external forces, thereby preventing any collision damage to the slide rail assembly 20.

Preferably, when the connecting portion 48 of the mounting fitting 26 is connected to the predetermined feature 46, the first engaging portion 52 and the second engaging portion 54 of the mounting fitting 26 are configured to stretch into the first gap G1 and the second gap G2 in a first predetermined direction M1 to engage with the first wall 68a and the second wall 68b of the second rail 24, e.g., in an embracing, holding or clamping manner, to restrain a displacement of the second rail 24, e.g., to prevent the second rail 24 from displacing away from the retracted position R in the opening direction D1 as shown in FIG. 8.

Preferably, the first engaging portion 52 includes a first arc surface 80 matching with a surface of a first ball groove of the first wall 68a of the second rail 24, and the second engaging portion 54 includes a second arc surface 82 matching with a surface of a second ball groove of the second wall 68b of the second rail 24. Accordingly, when the mounting fitting 26 is connected to the predetermined feature 46, the second rail 24 can be engaged by the first engaging portion 52 and the second engaging portion 54, e.g., in the embracing, holding or clamping manner, so as to be restrained from displacing. As shown in FIG. 11, the first arc surface 80 and the second arc surface 82 are convex toward each other.

Preferably, as shown in FIG. 8, at least one restraining feature 86 is further arranged on the longitudinal wall 66 of the first rail 22. For example, the restraining feature 86 can be a protrusion. The restraining feature 86 is located adjacent to the second end 22b of the first rail 22. When the third rail 28 is retracted relative to the first rail 22, the restraining feature 86 is configured to block the second end 28b of the third rail 28 for preventing the third rail 28 from displacing in a retracting direction D2 opposite to the opening direction D1.

It should be noticed that the operating portion 58 of the mounting fitting 26 is configured to be operated by the user. For example, the operating portion 58 of the mounting fitting 26 can be operated by an operating force in a second predetermined direction M2 opposite to the first predetermined direction M1 to drive the first engaging portion 52 and the second engaging portion 54 to disengage from the first wall 68a and the second wall 68b of the second rail 24, respectively, and to drive the connecting portion 48 to be detached from the predetermined feature 46, so as to allow the second rail 24 and the third rail 28 to displace from the retracted position R in the opening direction D1.

Moreover, the second rail 24 and the third rail 28 can displace synchronously relative to the first rail 22 in the opening direction D1 through a synchronous mechanism, which is not shown in the figures, and therefore, in an alternative embodiment, the first engaging portion 52 and the second engaging portion 54 of the mounting fitting 26 can engage with the first wall 72a and the second wall 72b of the third rail 28, respectively, so as to prevent the second rail 24 and the third rail 28 from displacing away from the retracted position R in the opening direction D1.

From the above, the slide rail assembly 20 of the present invention includes the following characteristics.
1. The mounting fitting 26 can be connected to or detached from the predetermined feature 46 according to practical demands. When the mounting fitting 26 is connected to the predetermined feature 46, the mounting fitting 26 can prevent the second rail 24 from displacing away from the retracted position R relative to the first rail 22 by blocking the second rail 24 and the third rail 28 with the blocking portion 50, and/or by engagement of the first wall 68a and the first engaging portion 52 stretching into the first gap G1 and engagement of the second wall 68b of the second rail 24 and the second engaging portion 54 stretching into the second gap G2.
2. The lateral wall 36 of the first bracket 30 exceeds the first end 22a of the first rail 22 by the predetermined longitudinal distance K, and the predetermined feature 46 is arranged on the section of the lateral wall 36 of the first bracket 30 exceeding the first end 22a of the first rail 22.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A slide rail assembly (20) adapted for a rack, the slide rail assembly (20) **characterized by**:
a first rail (22), a first bracket (30) being arranged on the first rail (22), the first rail (22) being mounted on the rack by the first bracket (30);
a second rail (24) displaceable relative to the first rail (22) longitudinally; and
a mounting fitting (26) comprising a connecting portion (48);
wherein one of the first rail (22) and the first bracket (30) comprises a predetermined feature (46);
wherein when the second rail (24) is located at a retracted position (R) relative to the first rail (22) and the connecting portion (48) of the mounting fitting (26) is detachably connected to the predetermined feature (46), the mounting fitting (26) prevents the second rail (24) from displacing away from the retracted position (R) in an opening direction (D1).

2. The slide rail assembly (20) of claim 1, **characterized in that** the mounting fitting (26) further comprises a blocking portion (50), and when the second rail (24) is located at the retracted position (R) relative to the first rail (22) and the connecting portion (48) of the mounting fitting (26) is detachably connected to the predetermined feature (46), the blocking portion (50) of the mounting fitting (26) blocks the second rail (24) for preventing the second rail (24) from displacing away from the retracted position (R) in the opening direction (D1).

3. The slide rail assembly (20) of any of claims 1 to 2, further **characterized by** a third rail (28) movably mounted between the first rail (22) and the second rail (24).

4. The slide rail assembly (20) of claim 3, **characterized in that** each of the first rail (22), the second rail (24) and the third rail (28) comprises a first wall (64a, 68a, 72a), a second wall (64b, 68b, 72b) and a longitudinal wall (66, 70, 74) connected between the first wall (64a, 68a, 72a) and the second wall (64b, 68b, 72b), the slide rail assembly (20) further comprises an aid-sliding device (76), and the aid-sliding device (76) comprises a plurality of rolling balls (B1) supported between the first wall (64a, 68a, 72a) of the third rail (28) and the first wall (64a, 68a, 72a) of the second rail (24) and between the second wall (64b, 68b, 72b) of the third rail (28) and the second wall (64b, 68b, 72b) of the second rail (24).

5. The slide rail assembly (20) of claim 4, **characterized in that** when the second rail (24) is located at the retracted position (R) relative to the first rail (22), the plurality of rolling balls (B1) of the aid-sliding device (76) at a predetermined position (P) are neither supported between a non-supporting section of the first wall (64a, 68a, 72a) of the third rail (28) and a non-supporting section of the first wall (64a, 68a, 72a) of the second rail (24) nor between a non-supporting section of the second wall (64b, 68b, 72b) of the third rail (28) and a non-supporting section of the second wall (64b, 68b, 72b) of the second rail (24), such that a first gap (G1) is formed between the non-supporting section of the first wall (64a, 68a, 72a) of the third rail (28) and the non-supporting section of the first wall (64a, 68a, 72a) of the second rail (24) and a second gap (G2) is formed between the non-supporting section of the second wall (64b, 68b, 72b) of the third rail (28) and the non-supporting section of the second wall (64b, 68b, 72b) of the second rail (24), and the mounting fitting (26) further comprises a first engaging portion (52) configured to stretch into the first gap (G1) in a first predetermined direction (M1) to engage with the first wall (64a, 68a, 72a) of the second rail (24) for preventing the second rail (24) from displacing away from the retracted position (R) in the opening direction (D1).

6. The slide rail assembly (20) of claim 5, **characterized in that** the mounting fitting (26) further comprises a second engaging portion (54) configured to stretch into the second gap (G2) in the first predetermined direction (M1) to engage with the second wall (64b, 68b, 72b) of the second rail (24) for preventing the second rail (24) from displacing away from the retracted position (R) in the opening direction (D1).

7. The slide rail assembly (20) of claim 6, **characterized in that** the mounting fitting (26) further comprises an extending arm (56), the extending arm (56) comprises a first end (56a) and a second end (56b) opposite to the first end (56a), the connecting portion (48) is located adjacent to the first end (56a) of the extending arm (56), and the first engaging portion (52) and the second engaging portion (54) are located adjacent to the second end (56b) of the extending arm (56).

8. The slide rail assembly (20) of claim 7, **characterized in that** the mounting fitting (26) further comprises an operating portion (58) connected to the extending arm (56) and located adjacent to the second end (56b) of the extending arm (56).

9. The slide rail assembly (20) of claim 8, **characterized in that** the operating portion (58) is tilted at a predetermined angle (A) relative to the second end (56b) of the extending arm (56), and the operating portion (58) is configured to be operated by a force in a second predetermined direction (M2) opposite to the first predetermined direction (M1) to drive the first engaging portion (52) and the second engaging portion (54) to disengage from the first wall (64a, 68a, 72a) and the second wall (64b, 68b, 72b) of the second rail (24), respectively.

10. The slide rail assembly (20) of any of claims 6 to 9, **characterized in that** the first engaging portion (52) comprises a first arc surface (80) matching with a surface of a first ball groove of the first wall (68a) of the second rail (24), and the second engaging portion (54) comprises a second arc surface (82) matching with a surface of a second ball groove of the second wall (68b) of the second rail (24).

11. The slide rail assembly (20) of any of claims 6 to 10, **characterized in that** the first engaging portion (52) and the second engaging portion (54) are spaced from each other by a distance in a height direction and located at positions corresponding to each other.

12. The slide rail assembly (20) of any of claims 6 to 11, **characterized in that** the mounting fitting (26) has a first side (L1) and a second side (L2) opposite to the first side (L1), the first side (L1) and the second side (L2) of the mounting fitting (26) are an inner side and outer side of the mounting fitting (26), respectively, and the connecting portion (48), the first engaging portion (52) and the second engaging portion (54) are located at the second side L2 of the mounting fitting (26).

13. The slide rail assembly (20) of claim 2, **characterized in that** the mounting fitting (26) has a first side (L1) and a second side (L2) opposite to the first side (L1), the first side (L1) and the second side (L2) of the mounting fitting (26) are an inner side and outer side of the mounting fitting (26), respectively, a predetermined structure (60) is arranged on the second side (L2) of the mounting fitting (26) and protrudes from the second side (L2) of the mounting fitting (26) by a transversal distance (T), and the blocking portion (50) and the connecting portion (48) are formed on the predetermined structure (60).

14. The slide rail assembly (20) of any of claims 1 to 13, **characterized in that** the first rail (22) comprises a first end (22a) and a second end (22b) opposite to the first end (22a), the first bracket (30) comprises a lateral wall (36) exceeding the first end (22a) of the first rail (22) by a predetermined longitudinal distance (K), and the predetermined feature (46) is arranged on a section of the lateral wall (36) of the first bracket (30) exceeding the first end (22a) of the first rail (22).

15. The slide rail assembly (20) of any of claims 1 to 14, further **characterized by** a second bracket (32), the first rail (22) being mounted on a first post (62a) of the rack by the first bracket (30), and the first rail (22) being mounted on a second post (62b) of the rack by the second bracket (32).

## Amended claims

### Amended claims in accordance with Rule 137(2) EPC.

1. A slide rail assembly (20) adapted for a rack, the slide rail assembly (20) comprising:
a first rail (22), a first bracket (30) being arranged on the first rail (22), the first rail (22) being mounted on the rack by the first bracket (30);
a second rail (24) displaceable relative to the first rail (22) longitudinally; and
a mounting fitting (26) comprising a connecting portion (48);
wherein one of the first rail (22) and the first bracket (30) comprises a predetermined feature (46);
wherein when the second rail (24) is located at a retracted position (R) relative to the first rail (22) and the connecting portion (48) of the mounting fitting (26) is detachably connected to the predetermined feature (46), the mounting fitting (26) prevents the second rail (24) from displacing away from the retracted position (R) in an opening direction (D1);
**characterized in that** the first rail (22) comprises a first end (22a) and a second end (22b) opposite to the first end (22a), the first bracket (30) comprises a lateral wall (36) exceeding the first end (22a) of the first rail (22) by a predetermined longitudinal distance (K), and the predetermined feature (46) is arranged on a section of the lateral wall (36) of the first bracket (30) exceeding the first end (22a) of the first rail (22).

2. The slide rail assembly (20) of claim 1, **characterized in that** the mounting fitting (26) further comprises a blocking portion (50), and when the second rail (24) is located at the retracted position (R) relative to the first rail (22) and the connecting portion (48) of the mounting fitting (26) is detachably connected to the predetermined feature (46), the blocking portion (50) of the mounting fitting (26) blocks the second rail (24) for preventing the second rail (24) from displacing away from the retracted position (R) in the opening direction (D1).

3. The slide rail assembly (20) of any of claims 1 to 2, further **characterized by** a third rail (28) movably mounted between the first rail (22) and the second rail (24).

4. The slide rail assembly (20) of claim 3, **characterized in that** each of the first rail (22), the second rail (24) and the third rail (28) comprises a first wall (64a, 68a, 72a), a second wall (64b, 68b, 72b) and a longitudinal wall (66, 70, 74) connected between the first wall (64a, 68a, 72a) and the second wall (64b, 68b, 72b), the slide rail assembly (20) further comprises an aid-sliding device (76), and the aid-sliding device (76) comprises a plurality of rolling balls (B1) supported between the first wall (64a, 68a, 72a) of the third rail (28) and the first wall (64a, 68a, 72a) of the second rail (24) and between the second wall (64b, 68b, 72b) of the third rail (28) and the second wall (64b, 68b, 72b) of the second rail (24).

5. The slide rail assembly (20) of claim 4, **characterized in that** when the second rail (24) is located at the retracted position (R) relative to the first rail (22), the plurality of rolling balls (B1) of the aid-sliding device (76) at a predetermined position (P) are neither supported between a non-supporting section of the first wall (64a, 68a, 72a) of the third rail (28) and a non-supporting section of the first wall (64a, 68a, 72a) of the second rail (24) nor between a non-supporting section of the second wall (64b, 68b, 72b) of the third rail (28) and a non-supporting section of the second wall (64b, 68b, 72b) of the second rail (24), such that a first gap (G1) is formed between the non-supporting section of the first wall (64a, 68a, 72a) of the third rail (28) and the non-supporting section of the first wall (64a, 68a, 72a) of the second rail (24) and a second gap (G2) is formed between the non-supporting section of the second wall (64b, 68b, 72b) of the third rail (28) and the non-supporting section of the second wall (64b, 68b, 72b) of the second rail (24), and the mounting fitting (26) further comprises a first engaging portion (52) configured to stretch into the first gap (G1) in a first predetermined direction (M1) to engage with the first wall (64a, 68a, 72a) of the second rail (24) for preventing the second rail (24) from displacing away from the retracted position (R) in the opening direction (D1).

6. The slide rail assembly (20) of claim 5, **characterized in that** the mounting fitting (26) further comprises a second engaging portion (54) configured to stretch into the second gap (G2) in the first predetermined direction (M1) to engage with the second wall (64b, 68b, 72b) of the second rail (24) for preventing the second rail (24) from displacing away from the retracted position (R) in the opening direction (D1).

7. The slide rail assembly (20) of claim 6, **characterized in that** the mounting fitting (26) further comprises an extending arm (56), the extending arm (56) comprises a first end (56a) and a second end (56b) opposite to the first end (56a), the connecting portion (48) is located adjacent to the first end (56a) of the extending arm (56), and the first engaging portion (52) and the second engaging portion (54) are located adjacent to the second end (56b) of the extending arm (56).

8. The slide rail assembly (20) of claim 7, **characterized in that** the mounting fitting (26) further comprises an operating portion (58) connected to the extending arm (56) and located adjacent to the second end (56b) of the extending arm (56).

9. The slide rail assembly (20) of claim 8, **characterized in that** the operating portion (58) is tilted at a predetermined angle (A) relative to the second end (56b) of the extending arm (56), and the operating portion (58) is configured to be operated by a force in a second predetermined direction (M2) opposite to the first predetermined direction (M1) to drive the first engaging portion (52) and the second engaging portion (54) to disengage from the first wall (64a, 68a, 72a) and the second wall (64b, 68b, 72b) of the second rail (24), respectively.

10. The slide rail assembly (20) of any of claims 6 to 9, **characterized in that** the first engaging portion (52) comprises a first arc surface (80) matching with a surface of a first ball groove of the first wall (68a) of the second rail (24), and the second engaging portion (54) comprises a second arc surface (82) matching with a surface of a second ball groove of the second wall (68b) of the second rail (24).

11. The slide rail assembly (20) of any of claims 6 to 10, **characterized in that** the first engaging portion (52) and the second engaging portion (54) are spaced from each other by a distance in a height direction and located at positions corresponding to each other.

12. The slide rail assembly (20) of any of claims 6 to 11, **characterized in that** the mounting fitting (26) has a first side (L1) and a second side (L2) opposite to the first side (L1), the first side (L1) and the second side (L2) of the mounting fitting (26) are an inner side and outer side of the mounting fitting (26), respectively, and the connecting portion (48), the first engaging portion (52) and the second engaging portion (54) are located at the second side L2 of the mounting fitting (26).

13. The slide rail assembly (20) of claim 2, **characterized in that** the mounting fitting (26) has a first side (L1) and a second side (L2) opposite to the first side (L1), the first side (L1) and the second side (L2) of the mounting fitting (26) are an inner side and outer side of the mounting fitting (26), respectively, a predetermined structure (60) is arranged on the second side (L2) of the mounting fitting (26) and protrudes from the second side (L2) of the mounting fitting (26) by a transversal distance (T), and the blocking portion (50) and the connecting portion (48) are formed on the predetermined structure (60).

14. The slide rail assembly (20) of any of claims 1 to 13, further **characterized by** a second bracket (32), the first rail (22) being mounted on a first post (62a) of the rack by the first bracket (30), and the first rail (22) being mounted on a second post (62b) of the rack by the second bracket (32).
